# EUROPÄISCHE PATENTSCHRIFT

(11) **EP 2 009 794 B1**
(45) Veröffentlichungstag und Bekanntmachung des Hinweises auf die Patenterteilung: **26.12.2012**
(21) Anmeldenummer: 08104245.9
(22) Anmeldetag: 04.06.2008
(51) Int. Cl.: H03K 17/687, H02H 7/09

(54) **Trennrelais**
Cutoff relay
Relais de coupure

(30) Priorität: 18.06.2007 DE 102007027895
(43) Veröffentlichungstag der Anmeldung: 31.12.2008
(73) Patentinhaber: Robert Bosch GmbH, 70442 Stuttgart (DE)
(72) Erfinder: Heusel, Jochen, 72768 Reutlingen (DE); Neuburger, Martin, 73312 Geislingen (DE)

(56) Entgegenhaltungen:
- EP-A- 1 104 080
- WO-A-03/099632
- US-A- 5 670 858
- US-A1- 2007 127 182

## Beschreibung

### Technisches Gebiet

Die Erfindung betrifft elektronische Trennrelais.

### Stand der Technik

Zum Schalten von hohen Strömen in elektrischen Systemen werden üblicherweise Relais verwendet. In jüngster Zeit werden dabei mechanische Relais zunehmend durch elektronische Relais ersetzt. Elektronische Relais umfassen Halbleiterschalter, wie z.B. MOS-FETS, IGBTs und dgl., die nahezu leistungsfrei angesteuert werden können, und eine geringe Verlustleistung aufweisen. Elektronische Relais haben den Vorteil, dass sie gegenüber mechanischen Relais eine geringere Größe aufweisen und zuverlässiger sind.

Neben dem Trennen einer elektrischen Last von der Versorgungsspannung kann es insbesondere beim Vorliegen von induktiven Lasten erforderlich sein, weitere Knoten innerhalb oder außerhalb der zu schaltenden Last aufzutrennen, um negative Auswirkungen durch in den Lasten induzierte Ströme zu vermeiden. Z.B. treten bei einem mehrphasigen Elektromotor, wie z.B. bei einem mehrphasigen permanenterregten Synchronmotor bei Fremderregung induzierte Phasenströme auf, die trotz nicht-anliegenden Versorgungsspannungen nach einem Abschalten zu einem Bremsmoment des Elektromotors führen können. Wenn ein solcher Elektromotor beispielsweise in einem Lenksystem eines Kraftfahrzeugs verwendet wird, kann dies bei einem Ausfall des Elektromotors zu einer Beeinträchtigung der Lenkbarkeit und dadurch zu einer Gefährdung des Fahrers führen. Daher sind bei Elektromotoren, deren Phasenstränge in einer Sternschaltung miteinander verschaltet sind, der gemeinsame Knoten der Sternschaltung mit einem elektronischen Relais versehen, das durch ein geeignetes Steuersignal geöffnet werden kann, so dass die Phasenstränge des Elektromotors voneinander getrennt werden.

Aus der Druckschrift WO 03/099 632 A1 ist ein elektronisch kommutierbarer Motor bekannt, der über eine Inverterschaltung ansteuerbar ist. Die Motorspulen sind in Sternschaltung miteinander verschaltet, wobei der Sternpunkt mit MOSFET-Schaltern ausgebildet ist, so dass der Sternpunkt aufgetrennt werden kann. Bei einem Fehler beim Betrieb des Motors ist vorgesehen, den Sternpunkt durch Öffnen der MOSFET-Schalter aufzutrennen.

Aus der Druckschrift EP 1104080A2 ist eine Motorschaltung mit einem Asynchronmotor, der in Sternschaltung betrieben wird, bekannt. Die Sternpunktverbindung des Elektromotors wird mittels eines elektronischen Leistungsschalters geschlossen oder geöffnet. Eine Steuerelektronik beeinflusst eine Ansteuerungseinheit, mit der der elektronische Leistungsschalter angesteuert werden kann. Eine Messeinrichtung versorgt die Steuerelektronik mit Informationen oder Signalen über die Spannungen und/oder Phasenlagen der Netzphasen.

Die Druckschrift US 5, 670, 858 offenbart ein Steuergerät zum Betreiben eines Wechselstrominduktionsmotors, wobei zum Ein- und Abschalten der Versorgungsspannung an den Elektromotor ein Triac vorgesehen ist, der abhängig von der Detektion eines Überstroms auf einer der Versorgungsleitungen geschaltet wird.

### Offenbarung der Erfindung

Es ist Aufgabe der vorliegenden Erfindung, eine verbesserte Ansteuerung eines elektronischen Relais, insbesondere zum Auftrennen eines Knotens bei einer induktiven Last zur Verfügung zu stellen, die weiterhin in einfacher Weise implementierbar ist.

Diese Aufgabe wird durch das Trennrelaissystem nach Anspruch 1 gelöst.

Weitere vorteilhafte Ausgestaltungen der Erfindung sind in den abhängigen Ansprüchen angegeben.

Gemäß einem ersten Aspekt ist die Trennrelaisschaltung, insbesondere zum Auftrennen eines Sternpunktes eines mehrphasigen Elektromotors, vorgesehen. Die Trennrelaisschaltung umfasst eine Last zum Betreiben über mehrere Versorgungsleitungen, ein elektronisches Trennrelais mit einem oder mehreren Schalttransistoren, um einen elektrischen Knoten K der Last auszubilden oder diesen aufzutrennen, sowie eine Steuerschaltung zum Ansteuern des Trennrelais abhängig von einem elektrischen Zustand auf mindestens einer der mehreren Versorgungsleitungen.

Das deartiges Trennrelaissystem ermöglicht es in einfacher Weise, beim Ausschalten einer Last einen weiteren Knoten durch ein Trennrelais aufzutrennen, ohne dass dies durch ein zusätzlich bereitgestelltes Steuersignal signalisiert werden muss. Somit ist das elektronische Trennrelais einschließlich seiner Ansteuerung gemeinsam mit der entsprechenden Last integrierbar. Weiterhin kann in einfacher Weise das Öffnen des Trennrelais signalisiert werden, indem ein bestimmter Signalverlauf auf den Versorgungsleitungen angelegt wird. Insbesondere wird das Öffnen des Trennrelais durch ein Abschalten der Ansteuerspannungen für die Last signalisiert.

Weiterhin kann die Last über mehrere Ansteuerspannungen mit sich zeitlich ändernden Pegeln betreibbar sein, wobei die Steuerschaltung ausgebildet ist, um den Knoten mit Hilfe des Trennrelais zu bilden, wenn eine Spannungsdifferenz zwischen den Ansteuerspannungen einen sich zeitlich ändernden Pegel aufweist, und um den Knoten mit Hilfe des Trennrelais aufzutrennen, wenn eine Spannungsdifferenz zwischen den Ansteuerspannungen einen konstanten Pegel aufweist.

Das elektronische Trennrelais ist mit einem oder mehreren Schalttransistoren, insbesondere mit MOSFETs oder IGBTs, ausgebildet, und wobei die Steuerschaltung erfindungsgemäß eine Bereitstellungsschaltung aufweist, um eine Steuergröße zum Schließen der Schalttransistoren bereitzustellen, so dass der Knoten ausgebildet wird.

Die Bereitstellungsschaltung weist eine Ladungspumpe auf, um eine Steuerspannung zum Schließen der Schalttransistoren bereitzustellen, so dass der Knoten ausgebildet wird.

Source-Anschlüsse der Schalttransistoren sind mit dem Knoten verbunden, wobei die Ladungspumpe eine Steuerspannung bereitstellt, die geeignet ist, um bei Anlegen an Gate-Anschlüsse der Schalttransistoren eine Gate-Source-Spannung bereitzustellen, die bei jedem während des Betriebs der Last auftretenden Knotenpotential ein sicheres Schließen der Schalttransistoren gewährleistet.

In Weiterbildung der Erfindung kann die Last eine Induktivität aufweisen, wobei die Steuerschaltung eine Ansteuereinheit aufweist, um bei Auftreten einer Induktionsspannung in der Induktivität bei abgeschalteten Zustand der Last ein Anlegen der Steuergröße an das elektrische Trennrelais zu unterbinden, wobei Gate-Anschlüsse und Source-Anschlüsse der Schalttransistoren über einen elektrischen Widerstand gekoppelt sind, so dass bei nicht anliegender Steuergröße die Gate-Anschlüsse mit dem Knotenpotential beaufschlagt werden und durch die resultierenden 0 Volt als Gate-Source-Spannung die Schalttransistoren zuverlässig geöffnet werden.

Gemäß einer weiteren Ausführungsform ist ein Tiefpass zwischen der Bereitstellungsschaltung und dem Trennrelais vorgesehen, um die Steuergröße Tiefpass zu filtern.

Insbesondere kann der der Knoten floatend vorgesehen sein.

Gemäß einem weiteren Aspekt ist ein Verfahren zum Steuern eines elektronischen Trennrelais, insbesondere zum Auftrennen eines Sternpunktes eines mehrphasigen Elektromotors, bekannt. Das Verfahren umfasst die Schritte des Betreibens einer Last über mehrere Versorgungsleitungen und des Ausbildens oder Auftrennens eines elektrischen Knotens K der Last abhängig von einem elektrischen Zustand auf mindestens einer oder mehreren Versorgungsleitungen.

### Kurzbeschreibung der Zeichnungen

Bevorzugte Ausführungsformen der Erfindung werden nachfolgend anhand der beigefügten Zeichnungen näher erläutert.
- Fig. 1: zeigt eine schematische Darstellung eines Trennrelaissystems;
- Fig. 2: zeigt eine detailliertere Darstellung eines Trennrelaissystems in analoger Ausführung gemäß einer Ausführungsform der Erfindung.

### Ausführliche Beschreibung der Ausführungsformen

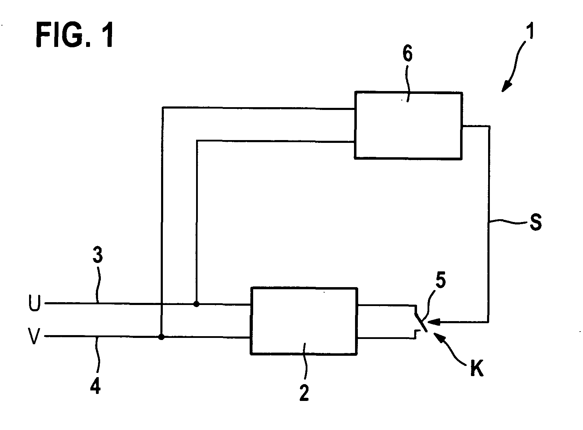

Fig. 1 zeigt eine schematische Darstellung eines Trennrelaissystems. Das dargestellte System 1 umfasst eine elektrische Last 2, die über zwei Versorgungsleitungen 3, 4 mit elektrischer Energie versorgt wird, d.h. an die über die zwei Versorgungsleitungen 3, 4 Ansteuerspannungen, vorzugsweise als Phasenspannungen mit wechselnden Pegeln, angelegt wird. Die elektrische Last 2 weist einen elektrischen Knoten K auf, der über ein elektronisches Trennrelais 5 geöffnet werden kann. Das elektronische Trennrelais 5 ist vorzugsweise mithilfe eines oder mehrerer MOSFETs, IGBTs oder anderen Leistungstransistoren ausgebildet. Das elektronische Trennrelais 5 wird gesteuert durch ein Schaltsignal S, das von einer Steuereinheit 6 zur Verfügung gestellt wird, und beispielsweise an einen entsprechenden Gate-Anschluss des oder der Leistungstransistoren angelegt wird.

Die Steuereinheit 6 ist im Wesentlichen so ausgebildet, dass sie abhängig von den Verläufen oder den Zuständen der auf den Versorgungsleitungen 3 und 4 anliegenden Versorgungsspannungen das Schaltsignal S generiert. D.h., z.B. bei einem bestimmten Spannungsverlauf auf den Versorgungsleitungen 3 und 4 generiert die Steuerschaltung 6 das Schaltsignal S, durch das das Trennrelais 5 geschlossen wird, so dass der Knoten K gebildet wird. Fehlt der bestimmte Spannungsverlauf so ändert sich das Schaltsignal S oder dieses wird abgeschaltet, so dass das Trennrelais 5 geöffnet wird, um den Knoten K aufzutrennen. Insbesondere kann dieses Schaltsignal S bei einem Abschalten der Ansteuerspannungen (die Potentiale der Versorgungsleitungen sind gleich bzw. betragen beide 0V) gebildet werden, die in geeigneter Weise durch die Steuereinheit 6 erkannt werden, um das entsprechende Schaltsignal S bereitzustellen. D.h. ein Auftrennen des Knotens K kann durch eine (nicht gezeigte) Ansteuerung des Systems 1 über die Versorgungsleitungen 3, 4 vorgenommen werden.

Handelt es sich bei der Last 2 um eine Last, die als Ansteuerspannungen Spannungen mit wechselnden Pegeln benötigt, wie es z.B. bei einem mehrphasigen Elektromotor der Fall ist, so ist es vorteilhaft, wenn ein Abschalten des Elektromotors durch Festlegen der Ansteuerspannungsphasen U, V auf feste Potenziale vorzugsweise auf das gleiche Potenzial erfolgt. Da die Phasenstränge des als Elektromotor ausgebildeten Last 2 miteinander über den Knoten K verbunden sind, soll nun die Steuereinheit 6 mithilfe des Schaltsignals den Knoten K auftrennen. Die Steuereinheit 6 ist daher mit den Versorgungsleitungen 3, 4 verbunden, und erkennt daran, dass anstelle von Ansteuerspannungen mit wechselnden Pegeln nun konstante Pegel anliegen, was die Folge eines Abschaltens des Elektromotors durch eine (nicht gezeigte) die Ansteuerspannungen bereitstellende Ansteuereinheit ist. Die Steuereinheit 6 generiert daraufhin das entsprechende Schaltsignal S oder schaltet das entsprechende Schaltsignal ab, um das elektronische Trennrelais 5 aufzutrennen.

Da in einem solchen Abschaltfall über die Versorgungsleitungen 3, 4 keine Energie mehr übertragen wird, wird erfindungsgemäß sein, in die Steuerschaltung 6 einen Energiespeicher, z.B. in Form eines Kondensators und dgl., vorgesehen , um auch nach dem Abschalten der Ansteuerspannungen auf den Versorgungsleitungen 3, 4 ein bestimmtes Schaltsignal S an das elektronische Trennrelais 5 anlegen zu können, um dieses z.B. verzögert aufzutrennen. In einem solchen Ausführungsbeispiel wertet die Steuerschaltung 6 das auf den Versorgungsleitungen 3, 4 anliegenden Ansteuerspannungen aus und solange die Spannungsdifferenz wechselnde Pegel aufweist, steuert die Steuereinheit 6 das elektronische Trennrelais 5 an, so dass dieses geschlossen bleibt. Weist die Spannungsdifferenz zwischen den Phasenleitungen 3 und 4 keinen wechselnden Pegel mehr auf oder beträgt diese sogar konstant 0 V, so generiert die Steuereinheit 6 ein Schaltsignal S, durch das der Knoten K des Elektromotors mit Hilfe des elektronischen Trennrelais 5 aufgetrennt wird. Dadurch können im beschriebenen Ausführungsbeispiel Bremsmomente und dgl., die bei einer weiteren Drehung des Rotors des Elektromotors auch nach dem Abschalten der Ansteuerspannungen auftreten können, vermieden werden.

Die Steuereinheit 6 ist vorzugsweise so gestaltet, dass das elektronische Trennrelais 5 durch Anlegen einer Steuerspannung geschlossen wird, so dass der Knoten K gebildet wird, während, wenn die Ansteuerung des Elektromotors abgeschaltet wird, d.h. die Ansteuerspannungen abgeschaltet bzw. auf einen konstanten Pegel (0V) gesetzt werden, die Leistungstransistoren des Trennrelais 5 durch Wegnahme des Schaltsignals, d.h. der entsprechenden Steuerspannung, geöffnet werden, so dass der Knoten K aufgetrennt wird.

Eine solche Steuereinheit ist allgemein in analoger und digitaler Schaltungstechnik realisierbar.

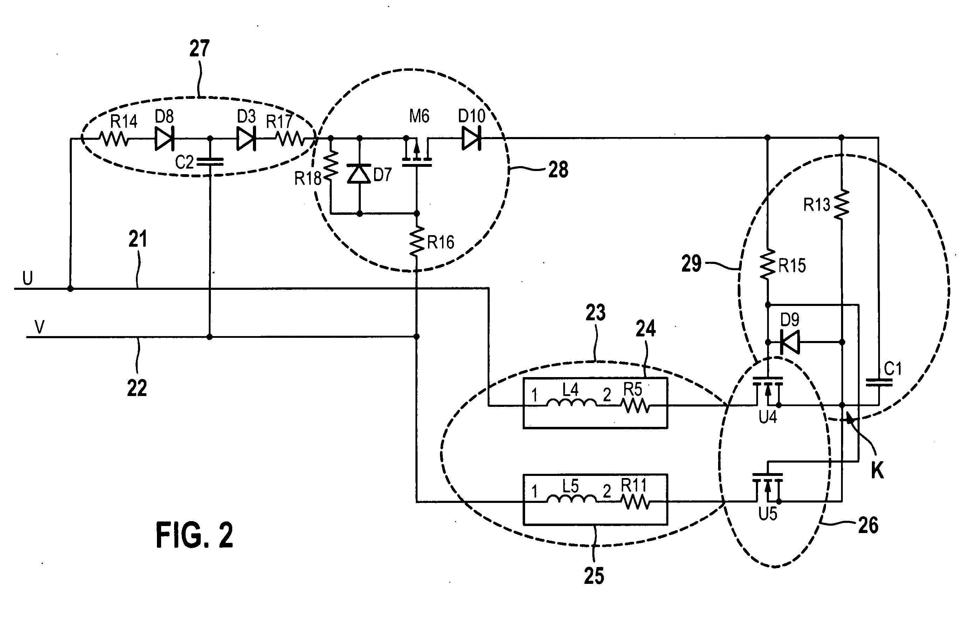

In Fig. 2 ist eine weitere Ausführungsform eines Trennrelaissystems in analoger Schaltungstechnik detailliert dargestellt.

Über eine erste Phasenleitung 21 und eine zweite Phasenleitung 22 werden ein erster Phasenstrang 24 eines Elektromotors 23 bzw. ein zweiter Phasenstrang 25 des Elektromotors 23 mit elektrischer Energie versorgt und dadurch der Elektromotor 23 angetrieben. Der Elektromotor 23 kann beispielsweise ein mehrphasiger Synchronmotor sein. Die Anzahl der Phasenleitungen bzw. der Phasenstränge des Elektromotors ist nicht auf zwei beschränkt, sonder kann im Wesentlichen jede beliebige Anzahl größer als 1 betragen. Die Phasenstränge 24, 25 sind über einen Knoten K miteinander verbunden, so dass die Phasenstränge 24, 25 in einer Sternschaltung betrieben werden. Der Knoten K wird mithilfe einer Trennrelaisschaltung 26 gebildet, die mithilfe von Leistungstransistoren U4, U5 die in jeweils einem entsprechenden Phasenstrang 24, 25 angeordnet sind und die gemeinsam mit dem Knoten K verbunden sind. Die Trennrelaisschaltung 26 ist geschlossen, wenn beide Leistungstransistoren U4, U5 leitend sind und geöffnet, wenn die Leistungstransistoren U4, U5 im wesentlichen nicht-leitend sind.

Der erste und der zweite Phasenstrang 24, 25 werden im Wesentlichen durch die Spulenwicklung des Elektromotors 23 gebildet und sind in Fig. 2 in Form eines Ersatzschaltbildes einer Reihenschaltung mit einer Induktivität L4 und einem Widerstandselement R5 bzw. einer Reihenschaltung mit einer Induktivität L5 und einem Widerstandsbauelements R11 dargestellt. Zur Ansteuerung der Leistungstransistoren U4, U5 der Trennrelaisschaltung 26 sind eine Ladungspumpe 27, eine Ansteuereinheit 28 und ein Tiefpass 29 vorgesehen. Der Elektromotor 23 wird durch mehrere (zwei) Phasen von Ansteuerspannungen mit wechselnden Pegeln über die Versorgungsleitungen 21, 22 betrieben. Die Spannungsdifferenz zwischen den zwei Ansteuerspannungen auf den Versorgungsleitungen 21, 22 wird beim Einschalten des Elektromotors 23 dazu benutzt, zunächst die Trennrelaisschaltung 26 zu schließen, so dass die Phasenstränge 24, 25 des Elektromotors 23 über den Knoten K miteinander verbunden werden. Das Schließen der Trennrelaisschaltung erfolgt durch das Zusammenwirken der Ladungspumpe 27, der Ansteuereinheit 28 sowie des Tiefpasses 29. Zum Schließen der Trennrelaisschaltung 26 müssen die Leistungstransistoren an ihren Gate-Anschlüssen mit einer Steuerspannung angesteuert werden, die die entsprechenden Leistungstransistoren sicher schließt, d.h. leitend macht. Da das Knotenpotenzial an dem Knoten K floatend ist, kann dieser auch ein Potenzial annehmen, der dem höchsten auf den Phasenleitungen 21, 22 angelegten Versorgungsspannungspotenzialen entspricht. Da ein Schließen (leitend Machen) der Leistungstransistoren vom n-Kanal-Typ hier eine positive Gate-Source-Spannung voraussetzt, muss zum zuverlässigen Aufsteuern der Leistungstransistoren U4, U5 an dessen Gate-Anschlüssen eine Steuerspannung (Potenzial) angelegt werden, die größer als das maximal an dem Knoten K auftretende Knotenpotenzial ist. Eine solche Steuerspannung wird mithilfe der Ladungspumpe 27 generiert.

Die Ladungspumpe 27 weist im Wesentlichen einen Kondensator C2 auf, der in Reihe mit einem Widerstandselement R14 und einer Diode D8 zwischen der ersten Phasenleitung 21 und der zweiten Phasenleitung 22 in Reihe geschaltet sind. Die Diode D8 ist so gerichtet, dass bei einer positiven Spannungsdifferenz zwischen der ersten Phasenleitung 21 und der zweiten Phasenleitung 22 der Kondensator C2 aufgeladen wird, jedoch bei einer negativen Spannungsdifferenz nicht entladen wird. Da eine positive Spannungsdifferenz nur auftritt, wenn sich die Phasenspannung auf der zweiten Phasenleitung 22 nicht auf ihrem maximalen Niveau befindet, wird nachfolgend, sobald die Phasenspannung der zweiten Phasenleitung 22 ansteigt, das Potenzial an einem Knoten zwischen der Diode D8 und dem Kondensator C2 angehoben, und zwar über eine maximale Ansteuerspannung hinaus, die auf der zweiten Phasenleitung 21, 22 auftreten kann. Das Potenzial an dem Knoten der Ladungspumpe 27 wird über eine weitere Diode D3 und ein Widerstandselement R17 an die Ansteuereinheit 28 weitergegeben. Die Ansteuereinheit 28 dient dazu, beim Betrieb des Elektromotors das Potenzial aus der Ladungspumpe im Wesentlichen über den Tiefpass 29 an die Trennrelaisschaltung 26 anzulegen. Weiterhin dient die Ansteuereinheit 28 dazu, im abgeschalteten Zustand zu verhindern, dass bei einem Generatorbetrieb des Elektromotors, bei dem Spannungen in den Phasensträngen 24, 25 induziert werden, die Leistungstransistoren U4, U5 der Trennrelaisschaltung 26 durch einen Abfall des Knotenpotentials aufgrund einer positiven Gate-Source-Spannung in einen leitenden Zustand versetzt werden.

Beim Betrieb des Elektromotors 23 wird die von der Ladungspumpe 27 bereitgestellte Spannung über die im wesentlichen durchgeschaltete Ansteuereinheit 28 an den Tiefpass 29 angelegt. Der Tiefpass 29 legt das Schaltpotenzial über ein Widerstandselement R15 an die Steueranschlüsse der Leistungstransistoren U4, U5 an. Weiterhin wird das Schaltpotenzial über ein Widerstandselement R13 und einen Kondensator C4 an dem Knoten K angelegt, wobei der Knoten K über eine Diode D9 mit den Steueranschlüssen der Leistungstransistoren U4, U5 verbunden ist. Die Diode D9 dient dazu, die Leistungstransistoren U4, U5 vor zu hohen negativen Gate-Source-Spannungen zu schützen.

Da die über die Ladungspumpe 27 bereitgestellte Spannung höher ist als die maximal auf den Phasenleitungen 21, 22 und damit auch an dem Knoten K auftretende Spannung, ist bei Anliegen von Ansteuerspannungen U, V mit wechselnden Pegeln ein Schließen der Leistungstransistoren U4, U5 gewährleistet. Weiterhin wird durch die Diode D9 ein Rückspeisen in die Ansteuereinheit 28 aufgrund eines springenden Potenzials an den Endstufen vermieden.

Der Tiefpass 29 dient für die Gate-Ansteuerung und es können damit Mindesteinschaltzeiten erreicht werden, wodurch z.B. im System vorhandene Energien im Fehlerfall im System abgebaut werden können und nicht am Relais anfallen.

Die Ansteuereinheit 28 weist einen Transistor, insbesondere einen Leistungstransistor M6 vom p-Kanal-Typ auf, der bei einer positiven Gate-Source-Spannung sperrt. Der Transistor M6 wird analog betrieben und eine Gate-Source-Spannung mithilfe eines Spannungsteilers, der durch das Widerstandselement R17 der Ladungspumpe, einem Widerstandselement R18, das zwischen Gate- und Source-Anschluss des Transistors M6 angeschlossen ist, und einem Widerstandselement R16, das zwischen der zweiten Versorgungsleitung 22 und dem Gate-Anschluss des Transistors M6 angeschlossen ist, gebildet wird, aus der von der Ladungspumpe bereitgestellten Spannung erzeugt. Weiterhin ist eine Diode D7 zwischen Gate-Anschluss und Source-Anschluss des Transistors M6 vorgesehen, um die Gate-Source-Spannung auf die Diodenspannung zu begrenzen.

Dadurch wird eine leicht positive Gate-Source-Spannung angelegt, die bewirkt, dass der Transistor M6 das von der Ladungspumpe 27 bereitgestellte Potential an über den Tiefpass 29 an die Trennrelaisschaltung anlegt, d.h. der Drain-Anschluss des Transistors M6 ist über eine Diode D10 mit dem Tiefpass 29 verbunden. Die Diode D10 dient dazu einen Rückschluss von dem Knoten K über den Tiefpass 29 zu der Ansteuerschaltung zu verhindern.

Im eingeschalteten Betrieb des Elektromotors liefert die Ladungspumpe eine über die Phasenspannung erhöhte Spannung, die über die Ansteuereinheit 28, d.h. über den teilweise leitenden Transistor M6 und die Diode D10 an den Tiefpass 29 weitergeleitet wird. Im abgeschalteten Betrieb, wenn z.B. die Phasenspannungen U, V jeweils 0 betragen, gewährleistet die Ansteuereinheit 28, dass bei Auftreten von induzierten Spannungen in den Phasensträngen des Elektromotors 23 keine positive Gate-Source-Spannung an den Leistungstransistoren U4, U5 des Trennrelais auftreten können, indem die Ansteuereinheit 28 die von der Ladungspumpe bereitgestellte Spannung von der Trennrelaisschaltung 26 trennt.

Eine positive Gate-Source-Spannung an den Transistoren U4, U5 der Trennrelaisschaltung bei abgeschaltetem Elektromotor 23 könnte bei gleichzeitiger leitender Ansteuereinheit 28 auftreten, wenn der Kondensator C2 der Ladungspumpe entladen ist und durch Diodenspannungen der Dioden D5, D3, D10 über das Widerstandselement R15 an den Gate-Anschlüssen der Leistungstransistoren U4, U5 anliegt. Wird eine Spannung in einem der Phasenstränge induziert, die das Knotenpotenzial auf ein Potenzial zieht, das kleiner ist als die an den Gate-Anschlüssen anliegende sich aus den Diodenspannungen ergebende Potential, so würden die Leistungstransistoren U4, U5 geschlossen und der Knoten K entsprechend beim Abschalten des Elektromotors nicht sofort aufgetrennt. Dadurch entstünde ein Bremsmoment, das vermieden werden soll. Daher ist die Ansteuereinheit 28 vorgesehen, die bei Auftreten einer induzierten Spannung in mindestens einem Phasenstrang des Elektromotors 23 sperrt, so dass sichergestellt ist, dass das Knotenpotenzial über die Widerstandselemente R13 und R15 auch an dem Gate-Anschluss der Leistungstransistoren U4, U5 anliegt, und somit die Gate-Source-Spannung der Leistungstransistoren U4, U5 auf 0 V einstellt, so dass diese geöffnet werden und der Knoten K selbst bei einer Spannungsinduktion in einem Phasenstrang aufgetrennt bleibt. Ein Einschalten erfolgt, sobald die Ladungspumpe eine über die maximale auf den Phasenleitungen 21, 22 auftretende Phasenspannung dem Tiefpass bereitgestellt hat, sodass dort eine positive Gate-Source-Spannung an den Leistungstransistoren U4, U5 angelegt werden kann.

## Patentansprüche

1. Trennrelaisschaltung, insbesondere zum Auftrennen eines Sternpunktes eines mehrphasigen Elektromotors, umfassend:
eine Last (2, 23) zum Betreibentüber mehrere Versorglingsleitungen (3, 4:21, 22); ein elektronisches Trennrelais (5; 26) mit einem oder mehreren Schalttransistoren, um einen elektrischen Knoten (K) der Last (2, 23) auszubilden oder diesen aufzutrennen:
eine Steuerschaltung (6; 27, 28, 29), welche ein Schaltsignal (S) zum Ansteuern des Trennrelais (5, 26) zu Verfügung stellt, wobei das Öffnen oder Schließen des elektronischen Trennrelais abhängig von einem elektrischen Zustand auf mindestens einer der mehreren Versorgungsleitungen (3, 4:21, 22) signalisiert wird, und die Steuerschaltung (6; 27, 28, 29) mit den Versorgungsleitungen (3, 4;21, 22) verbunden ist und ausgebildet ist, abhängig von den Verläufen oder den Zuständen der auf den Versorgungsleitungen (3, 4;21, 22) anliegenden Ansteuerspannungen das Schaltsignal (S) zu generieren,
wobei die Last über mehrere Ansteuerspannungen mit sich zeitlich ändernden Pegeln betreibbar ist, wobei die Steuerschaltung (6; 27, 28, 29) ausgebildet ist, um den Knoten (K) mit Hilfe des Trennrelais (26) zu bilden, wenn eine Spannungsdifferenz zwischen den Ansteuerspannungen einen sich zeitlich ändernden Pegel aufweist, und um den Knoten (K) mit Hilfe des Trennrelais aufzutrennen, wenn eine Spannungsdifferenz zwischen den Ansteuerspannungen einen konstanten Pegel aufweist, und
wobei das elektronische Trennrelais (26) mit einem oder mehreren der Shalttransistoren (U4, U5), insbesondere mit MOSFETs oder IGBTs, ausgebildet ist wobei Source-Anschlüsse der Schalttransistoren (U4, U5) mit dem Knoten (K) verbunden sind, **dadurch gekennzeichnet, dass** die Steuerschaltung (27, 28, 29) eine Bereitstellungsschaltung (27) aufweist, um das Schaltsignal (S) zum Schließen der Schalttransistoren bereitzustellen, so dass der Knoten (K) ausgebildet wird,
wobei die Bereitstellungsschaltung (27) ein Ladungspumpe (27) aufweist, um das Schaltsignal (S) in Form einer Steuerspannung zum Schließen der Schalttransistoren bereitzustellen, so dass der Knoten (K) ausgebildet wird,
wobei die Ladungspumpe die Steuerspannung bereitstellt, die geeignet ist, um bei Anlegen an Gate-Anschlüsse der Schalttransistoren (U4, U5) eine Gate-Source-Spannung bereitzustellen, die bei jedem während des Betriebs der Last auftretenden Knotenpotential ein sicheres Schließen der Schalttransistoren (U4, U5) gewährleistet.

2. Trennrelaisschaltung nach Anspruch 1 , wobei die Last eine Induktivität aufweist, wobei die Steuerschaltung (27, 28, 29) eine Ansteuereinheit (28) aufweist, um bei Auftreten einer Induktionsspannung in der Induktivität bei abgeschalteten Zustand der Last (23) ein Anlegen der Steuergröße an das elektrische Trennrelais (26) zu unterbinden, wobei Gate-Anschlüsse und Source-Anschlüsse der Schalttransistoren über einen elektrischen Widerstand gekoppelt sind, so dass bei nicht anliegender Steuergröße die Gate-Anschlüsse mit dem Knotenpotential beaufschlagt werden und durch die resultierenden 0 Volt als Gate-Source-Spannung die Schalttransistoren zuverlässig geöffnet werden.

3. Trennrelaisschaltung nach einem der Ansprüche 1 bis 2, wobei ein Tiefpass (29) zwischen der Bereitstellungsschaltung und dem Trennrelais (26) vorgesehen ist, um die Steuergröße Tiefpass zu filtern.

4. Trennrelaisschaltung nach einem der vorangehenden Ansprüche, wobei der Knoten (K) floatend vorgesehen ist.

## Claims

1. Cutoff relay circuit, in particular for opening a neutral point of a polyphase electric motor, comprising:
a load (2, 23) for operation over a plurality of power supply lines (3, 4; 21, 22);
an electronic cutoff relay (5; 26) with one or more switching transistors in order to form or open an electrical node (K) of the load (2, 23);
a control circuit (6; 27, 28, 29), which provides a switching signal (S) for actuating the cutoff relay (5, 26), wherein the opening or closing of the electronic cutoff relay is signalled depending on an electrical state on at least one of the plurality of power supply lines (3, 4; 21, 22), and the control circuit (6; 27, 28, 29) is connected to the power supply lines (3, 4; 21, 22) and is designed to generate the switching signal (S) depending on the profiles or the states of the actuating voltages present on the power supply lines (3, 4; 21, 22), wherein the load can be operated via a plurality of actuating voltages with temporally changing levels, wherein the control circuit (6; 27, 28, 29) is designed to form the node (K) with the aid of the cutoff relay (26) when a voltage difference between the drive voltages has a temporally changing level and to open the node (K) with the aid of the cutoff relay when a voltage difference between the actuating voltages has a constant level, and wherein the electronic cutoff relay (26) is designed to have one or more of the switching transistors (U4, U5), in particular MOSFETs or IGBTs, wherein source connections of the switching transistors (U4, U5) are connected to the node (K), **characterized in that** the control circuit (27, 28, 29) has a supply circuit (27) in order to supply the switching signal (S) for closing the switching transistors so that the node (K) is formed, wherein the supply circuit (27) has a charge pump (27) in order to supply the switching signal (S) in the form of a control voltage for closing the switching transistors so that the node (K) is formed, wherein the charge pump supplies the control voltage which is suitable for supplying a gate-source voltage when applied to gate connections of the switching transistors (U4, U5), which gate-source voltage ensures safe closing of the switching transistors (U4, U5) at each node potential occurring during operation of the load.

2. Cutoff relay circuit according to Claim 1, wherein the load has an inductance, wherein the control circuit (27, 28, 29) has an actuating unit (28) in order to suppress an application of the controlled variable to the electrical cutoff relay (26) in the event of the occurrence of an induced voltage in the inductance in the switched-off state of the load (23), wherein gate connections and source connections of the switching transistors are coupled via an electrical resistor, with the result that, when the controlled variable is not present, the node potential is applied to the gate connections, and, owing to the resulting 0 volt as gate-source voltage, the switching transistors are reliably opened.

3. Cutoff relay circuit according to one of Claims 1 to 2, wherein a low-pass filter (29) is provided between the supply circuit and the cutoff relay (26) for low-pass filtering of the controlled variable.

4. Cutoff relay circuit according to one of the preceding claims, wherein the node (K) is provided so as to be floating.

## Revendications

1. Circuit relais de sectionnement, notamment pour déconnecter un point neutre d'un moteur électrique à plusieurs phases, comprenant :
une charge (2, 23) à faire fonctionner par le biais de plusieurs lignes d'alimentation (3, 4 ; 21, 22) ;
un relais de sectionnement électronique (5 ; 26) muni d'un ou plusieurs transistors de commutation pour former un noeud électrique (K) de la charge (2, 23) ou pour déconnecter celui-ci ;
un circuit de commande (6 ; 27, 28, 29) qui délivre un signal de commutation (S) pour exciter le relais de sectionnement (5, 26), l'ouverture ou la fermeture du relais de sectionnement électronique étant signalée en fonction d'un état électrique sur au moins l'une des plusieurs lignes d'alimentation (3, 4 ; 21, 22), et le circuit de commande (6 ; 27, 28, 29) étant relié avec les lignes d'alimentation (3, 4 ; 21, 22) et configuré pour générer le signal de commutation (S) en fonction des tracés ou des états des tensions d'excitation présentes sur les lignes d'alimentation (3, 4 ; 21, 22),
la charge pouvant être mise en fonctionnement par le biais de plusieurs tensions d'excitation ayant des niveaux qui varient dans le temps, le circuit de commande (6 ; 27, 28, 29) étant configuré pour former le noeud (K) à l'aide du relais de sectionnement (26) lorsqu'une différence de tension entre les tensions d'excitation présente un niveau qui varie dans le temps et pour déconnecter le noeud (K) à l'aide du relais de sectionnement lorsqu'une différence de tension entre les tensions d'excitation présente un niveau constant, et
le relais de sectionnement électronique (5 ; 26) étant réalisé avec un ou plusieurs des transistors de commutation (U4, U5), notamment avec des MOSFET ou des IGBT, les bornes de source des transistors de commutation (U4, U5) étant reliées avec le noeud (K), **caractérisé en ce que** le circuit de commande (27, 28, 29) présente un circuit de délivrance (27) pour délivrer le signal de commutation (S) destiné à fermer les transistors de commutation, ce qui forme le noeud (K),
le circuit de délivrance (27) présentant une pompe de charge (27) pour délivrer le signal de commutation (S) sous la forme d'une tension de commande destinée à fermer les transistors de commutation, ce qui forme le noeud (K),
la pompe de charge délivrant la tension de commande, laquelle est conçue, lorsqu'elle est appliquée aux bornes de gâchette des transistors de commutation (U4, U5), pour délivrer une tension gâchette/source qui garantit une fermeture sécurisée des transistors de commutation (U4, U5) à chaque potentiel de noeud qui se produit pendant le fonctionnement de la charge.

2. Circuit relais de sectionnement selon la revendication 1, la charge présentant une inductance, le circuit de commande (27, 28, 29) présentant une unité d'excitation (28) pour inhiber une application de la grandeur de commande au relais de sectionnement électrique (26) lorsqu'il se produit une tension d'induction dans l'inductance à l'état déconnecté de la charge (23), les bornes de gâchette et les bornes de source des transistors de commutation étant connectées par le biais d'une résistance électrique de sorte que lorsque la grandeur de commande n'est pas appliquée, les bornes de gâchette soient soumises au potentiel du noeud et les transistors de commutation soient ouverts de manière fiable par la tension gâchette-source de 0 Volt résultante.

3. Circuit relais de sectionnement selon l'une des revendications 1 à 2, un filtre passe-bas (29) étant prévu entre le circuit de délivrance et le relais de sectionnement (26) pour effectuer un filtrage passe-bas de la grandeur de commande.

4. Circuit relais de sectionnement selon l'une des revendications précédentes, le noeud (K) étant prévu flottant.
